# EUROPEAN PATENT APPLICATION

(11) **EP 4 780 147 A1**
(43) Date of publication of application: **22.07.2026**
(21) Application number: 25222826.7
(22) Date of filing: 12.12.2025
(51) Int. Cl.: H05K 7/14

(54) **A MODULAR RACK SYSTEM SUITABLE FOR DISTRIBUTING ELECTRICAL INPUT/OUTPUT (I/O) SIGNALS**

(71) Applicant: ASML Netherlands B.V., 5500 AH Veldhoven (NL)
(72) Inventor: AKYAZI, Sinan, 5500 AH Veldhoven (NL); MADAN, Alican, 5500 AH Veldhoven (NL); MEULENDIJKS, Antonius, Lambertus, Theodorus, 5500 AH Veldhoven (NL); ROMO GALLEGO, Santiago, 5500 AH Veldhoven (NL); SMEETS, Eelco, Michiel, Theodorus, Henricus, 5500 AH Veldhoven (NL); THOMASSEN, Bart, Hendrikus, Carolus, 5500 AH Veldhoven (NL)
(74) Representative: ASML Netherlands B.V.

(57) **Abstract**

A modular rack system for distributing electrical input/output (I/O) signals is provided, comprising a I/O interface frame in a housing and structured to receive a plurality of removable I/O signal module units in a specific unit configuration and for distributing electrical I/O signals to and from the removable I/O signal module units. A configuration control module unit is provided for uniquely identifying the removable I/O signal module units received in the specific unit configuration and for distributing the electrical I/O signals to the I/O interface frame and to the removable I/O signal module units based on the specific unit configuration. Accordingly, the modular rack system architecture can be simplified as the I/O interface frame can be configured as standardized platform, with the configuration control module unit being the only customized component in the rack architecture and forming the control center for the intended semiconductor manufacturing process.

## Description

### FIELD

The present disclosure relates to the field of semiconductor manufacturing and more particularly to a modular rack system or rack for use in such semiconductor manufacturing environment. The present disclosure details a modular rack system or rack suitable for distributing electrical input/output (I/O) signals among various I/O signal module units accommodated in the rack system

### BACKGROUND

In semiconductor manufacturing equipment - such as photolithography, etch, or deposition tools - a modular rack system serves as a centralized control backbone for signal processing of input/output signals among the various subsystems being implemented. In the traditional configuration, such modular rack system consists of a backplane for multiple I/O module units, with each I/O module unit being designed for specific signal types and control functions in support of the intended semiconductor manufacturing process. Modular rack systems are known in the art in a variety of standards and one known standard is the VME rack system, based on a particular rack design for accommodating electronic circuit boards designed for and supporting the VME bus system.

Usually the modular rack system is configured in a specific configuration of the various I/O module units needed for the intended semiconductor manufacturing process. Often, the modular rack system is further complemented with additional components, such as passive/active power boards, power switches, AC/DC convertors, and configuration specific external cabling.

Due to the diversity of functional requirements needed for effectively perform various semiconductor manufacturing processes a traditional rack system can be configured in large number of different rack configurations. The proliferation of these various rack configuration creates a significant complexity in manufacturing, inventory and maintenance of the modular rack systems, the multiple I/O module units and supporting peripheral components.

Accordingly, there is a need for establishing a more standard modular rack system configuration, which can serve as a standard platform for a variety of rack module unit configurations for the various semiconductor manufacturing processes.

### SUMMARY

In a first aspect of the present disclosure, there is provided a modular rack system suitable for distributing electrical input/output (I/O) signals. The modular rack system according to the disclosure comprises a housing; a main power input; a I/O interface frame mounted in the housing, the I/O interface frame defining a number of compartments structured for at least receiving a plurality of removable I/O signal module units in a specific unit configuration thereof and for distributing electrical input/output (I/O) signals to and from the removable I/O signal module units. In addition, a configuration control module unit is provided, which is capable to uniquely identify the removable I/O signal module units being received in the specific unit configuration on the I/O interface frame. In particular, the configuration control module unit is further structured for distributing the electrical input/output (I/O) signals to the I/O interface frame and to the removable I/O signal module units based on the specific unit configuration of the removable I/O signal module units thus identified.

The configuration of the modular rack system as outlined above provides a standardized control backbone for the generation and distribution of electrical input/output (I/O) signals for a variety of I/O signal module units arranged in a particular configuration in the modular rack system depending on a particular semiconductor manufacturing process to be managed (monitored) and controlled. The modular rack system implements a configuration control module unit, which identifies each I/O signal module unit in a unique manner and subsequently arranges that each I/O signal module unit can be properly and correctly operated accordingly to their individual operational specifications and capabilities.

Accordingly, the modular rack system architecture can be simplified. The I/O interface frame can be configured as standardized platform capable to receive or accommodate any I/O signal module unit in any specific configuration, irrespective of the intended semiconductor manufacturing process. The configuration control module unit is the only customized component in the rack architecture and forms the control center for the intended semiconductor manufacturing process. The high level of commonality significantly simplifies the rack architecture, and the manufacturing process. Due to its simple, standardized platform architecture the number of rack components are less diverse, which accelerates the modular rack system assembly and reduces production costs.

In a further detail of the modular rack system according to the disclosure, each of the plurality of removable I/O signal module units comprises an identifier component. The configuration control module unit is structured to uniquely identify a removable I/O signal module unit based on the identifier component. Accordingly, this allows for the modular rack system and in particular the I/O interface frame to be configured as the standardized platform, with the diversification of the various modular rack system configurations being identifiable by the configuration control module unit.

In a further example of the modular rack system according to the disclosure, an AC/DC power convertor and one or more DC/DC power convertors are provided and the configuration control module unit is structured to configure or to set up the one or more DC/DC power convertors based on the specific unit configuration as identified. This allows the modular rack architecture to be configured with one main power supply, and only one AC/DC convertor, with any complex and expensive AC/DC power convertor being replaced by one or more compact, cost-effective DC/DC power convertors. Furthermore, the DC/DC power convertors provide DC power to the various removable I/O signal module units based on the specific rack configuration as identified by the configuration control module unit.

Additionally, the modular rack system/rack architecture according to the disclosure is operated on an all-DC voltage level, thus providing operator safety, preventing arcing, or minimizing electric shock risk. This also allows the complete modular rack system architecture to be manufacture at a lower cost.

In a further example of the modular rack system according to the disclosure the I/O interface frame comprises, for each defined compartment, a standardized I/O signal connector bus/type structured to mechanically and electrically interface with a corresponding standardized I/O signal connector bus/type of one of the plurality of removable I/O signal module units. This further simplifies the overall architecture, and reduces manufacturing costs, whilst maintain a maximum flexibility in cabinet configurations depending on the intended semiconductor manufacturing process.

In a further detail of the modular rack system according to the disclosure, the configuration control module unit may be a removable configuration control module unit. This further simplifies the overall architecture, as it will provide a modular rack system with a standard I/O interface frame, which forms the backbone structure for a variety of rack configurations.

In a further standardization detail, the I/O interface frame is formed of a first interface frame section defining a first group of compartments structured for receiving the plurality of removable I/O signal module units and a second interface frame section defining a second group of compartments structured for receiving the configuration control module and the one or more DC/DC power convertors.

Additionally, the configuration control module unit may comprises one or more power switch elements to turn on/off one or more of the I/O signal module units, one or more of the DC/DC power convertors or one or more groups of compartments. Herewith, a more versatile configuration control module unit is implemented capable of setting and controlling the power consumption within the modular rack system, e.g. by switching off module units within the configuration for service action.

### BRIEF DESCRIPTION OF THE DRAWINGS

Examples of the present disclosure will now be described, by way of example only, with reference to the accompanying schematic drawings, in which:
Figure 1 shows a three-dimensional cross sectional view of an example of a modular rack system according to the disclosure;
Figure 2 shows a detailed three-dimensional cross sectional view of an example of a modular rack system according to the disclosure;
Figure 3 shows a detailed view of an example of a modular rack system according to the disclosure;
Figure 4 shows a schematic depiction of a modular rack system according to the prior art compared to that of the disclosure.

### DETAILED DESCRIPTION

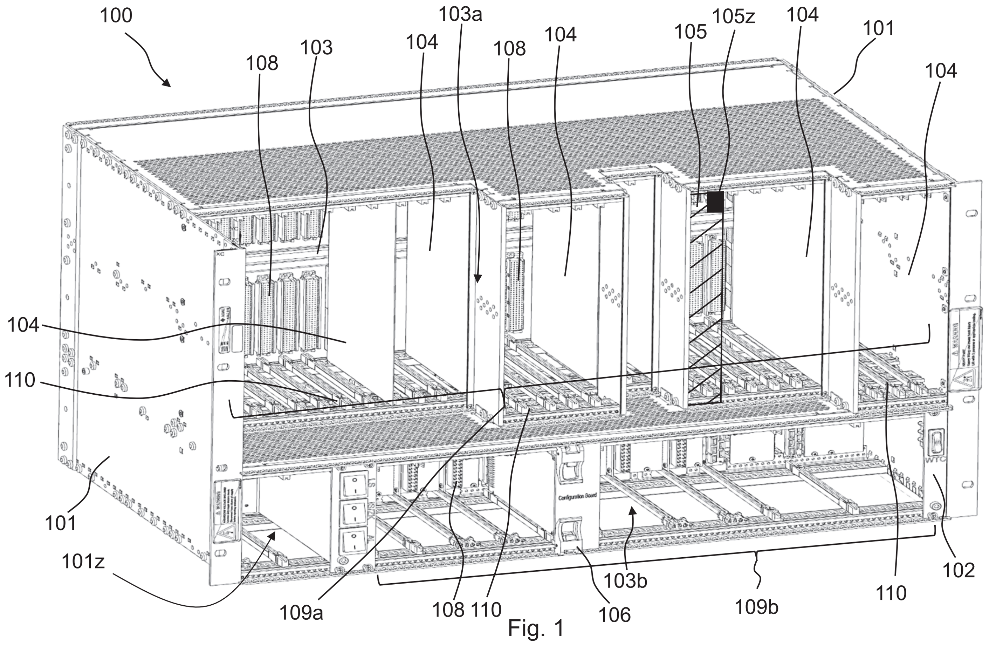

Figure 1 shows a three-dimensional cross sectional view of an example of a modular rack system according to the disclosure. The cabinet is denoted with reference numeral 100. As outlined in the introductionary part of this application, such modular rack system 100 serves in semiconductor manufacturing equipment - such as photolithography, etch, or deposition tools - as a centralized control backbone for signal processing of input/output signals among the various subsystems being implemented. In a traditional configuration, such modular rack system consists of a backplane for multiple I/O module units, with each I/O module unit being designed for specific signal types and control functions in support of the intended semiconductor manufacturing process.

Usually, in the known modular rack system, the various I/O module units needed for the intended semiconductor manufacturing process are arranged in a specific configuration or ranking. Often, the modular rack system is further complemented with additional components, such as passive/active power boards, power switches, AC/DC convertors, and configuration specific rack internal and rack external cabling.

The modular rack system 100 according to the disclosure has an improved standardized platform set up, capable of hosting a variety of I/O module units in a large number of different rack configurations irrespective of the intended semiconductor manufacturing process and irrespective of the diversity of functional requirements needed for effectively perform these semiconductor manufacturing processes.

To this end, the modular rack system 100 according to the disclosure implements a I/O interface frame 103 which is mounted in a housing 101. For the sake of a proper disclosure of the characterizing features of the rack 100, the housing 101 is shown in a partial open configuration. However is it to be understood, that the housing 101 properly houses and shields the relevant components of the rack 100 in a safe and reliable manner, with only a front side 101z of the housing 101 being accessible to (maintenance) personnel for arranging the various I/O module units in a particular configuration and to allow access for configuring and/or swapping those I/O module units.

The housing 101 can be formed of various panels which - when interconnected - form a spatial enclosure for accommodating the various components of the modular rack system 100. The housing 101 can be established as a fixed construction for placement on a support, or can be implemented with supporting wheels or rolls (not shown) allowing easy displacement and relocation. The housing 101 allows for incorporating a main power input (schematically denoted with 102) (for example 220-230 V AC) for supplying power to the modular rack system 100.

As shown, the I/O interface frame 103 may define a number of compartments, denoted with reference numeral 104, arranged in side-by-side abutting relationship. The I/O interface compartments 104 are capable for receiving one or more I/O signal module units 105 in a specific unit configuration or ranking. Here, each I/O signal module unit 105 is schematically depicted as a dashed box located in an I/O interface compartment 104. Preferably, but not required for a proper use and implementation of the modular rack system 100 according to the disclosure, the I/O signal module units 105 can be removable.

The I/O interface frame 103 is formed of a substrate having a rigid and sturdy build, and may be provided with proper wiring and/or metal traces for the distribution of electrical I/O signals along the I/O interface frame 103 and to and from the various I/O signal module units 105 mounted in each defined compartment 104. The electrical I/O signals to be generated and distributed can be in the form of voltage and current signals via the wiring and traces. To this end, in each I/O interface compartment 104, one or more, preferably one standardized I/O signal connector bus/type 108 may be provided. The standardized I/O signal connector bus/type 108 serves to for a mechanical and electrical interface with a corresponding standardized I/O signal connector bus/type of a corresponding I/O signal module unit 105 being mounted in the interface compartment 104. The use of a standardized I/O signal connector bus/type 108 simplifies the overall architecture of the modular rack system 100 as it reduces manufacturing costs, whilst maintain a maximum flexibility in cabinet configurations depending on the intended semiconductor manufacturing process. The use of standardized I/O signal connector types on both the interface frame 103 and the I/O signal module units 105 allows for an easy mounting and unmounting of an I/O signal module unit 105.

The housing 101 of the modular rack system 100 according to the disclosure may be provided with suitable linear guide mechanisms 110, such as rails, slides, or channels, in each I/O interface compartment 104. This enables a smooth insertion, alignment, and secure positioning of the I/O signal module unit 105, as well as an easy disengagement and removal of the I/O signal module unit 105 from the compartment.

Such linear guide mechanisms 110 also allow for a proper alignment, interconnection and disconnection of the I/O signal connector bus/type of the I/O signal module unit 105 with the complementary designed I/O signal connector bus/type 108 of the I/O signal module unit 105.

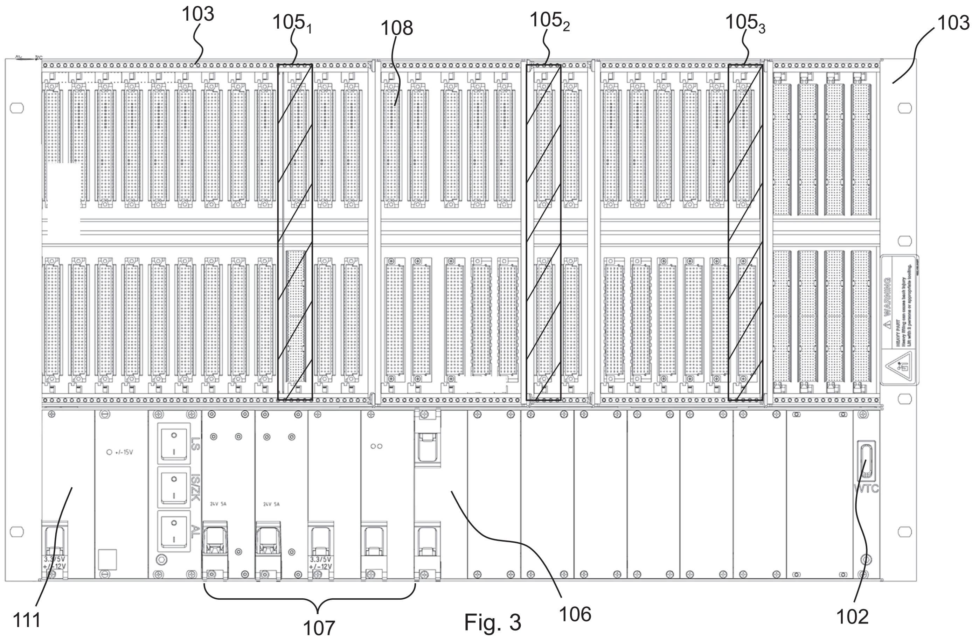

Reference numeral 106 denotes in a schematic manner a configuration control module unit. The configuration control module unit 106 is structured to uniquely identify each I/O signal module unit 105, which is received in a specific unit configuration on the I/O interface frame 103. With the configuration control module unit 106, the electrical I/O signals necessary for a proper operation of the various I/O signal module units 105 in the modular rack system 100 can be properly generated and more importantly distributed in a correct way to the I/O interface frame 103 and to the various I/O signal module units 105 (denoted 1051, 1052, 1053, etc. in Figure 3). The distribution of the correct I/O signals to the intended I/O signal module unit 105 is determined by the configuration control module unit 106 based on the distinguishing identities of the various I/O signal module units 105 in the particular the specific unit configuration in the modular rack system 100, which are identified by the configuration control module unit 106.

The design of the modular rack system 100, in particular the I/O interface frame 103 forming the various I/O compartments 104 in which the I/O signal module units 105 are mounted in a particular ranking or configuration, establishes a standardized control backbone for the generation and distribution of electrical I/O signals for the variety of I/O signal module units 105 arranged in that particular ranking in the modular rack system 100. The particular ranking of the variety of I/O signal module units 105 is defined by a particular semiconductor manufacturing process to be managed (monitored) and controlled. With the implementation of the control module unit 106, each I/O signal module unit 105 can be identified in a unique manner. The identification by the control module unit 106 ensures a proper signal addressing of each I/O signal module unit 105 and subsequent correct operation in accordance with their individual operational specifications and capabilities.

This results in a simplified architecture of the modular rack system 100. The I/O interface frame 103 is now formed as simplified and standardized platform capable to receive or accommodate any I/O signal module unit 105 within an interface compartment 104, in any specific configuration in combination with other I/O signal module units 105, irrespective of the intended semiconductor manufacturing process. The use of the standardized I/O signal connector busses 108 for each I/O interface compartment 104, which interact (or mesh) mechanically and electrically with a corresponding, yet complimentary designed I/O signal connector bus/type of an I/O signal module unit 105, creates a high level of commonality. This design significantly simplifies the rack architecture, and the manufacturing process. Due to its simple, standardized platform architecture the number of rack components forming the housing 101, and the I/O interface frame 103 are less diverse, which accelerates the modular rack system assembly and reduces production costs.

In fact, the only customized component in the modular rack system 100 according to the disclosure is the configuration control module unit 106, as it recognizes the unique identity and location of each I/O signal module unit 105 mounted at a particular I/O interface compartment 104 in the I/O interface frame 103. The various identities and unique locations of the various I/O signal module units 105 (e.g. denoted 1051, 1052, 1053, etc. in Figure 3) within the modular rack system 100 defines the specific rack configuration and the configuration control module unit 106 functions as the control center for controlling and monitoring the intended semiconductor manufacturing process.

In order to facilitate the unique identity of each I/O signal module unit 105 and subsequent mounting location in an I/O interface compartment 104 in the I/O interface frame 103, each I/O signal module unit 105 is provided with an identifier component 105z. Once an I/O signal module unit 105 is mounted in a particular I/O compartment 104 and a mechanical and electrical connection is established with the I/O signal connector bus/type 108, the configuration control module unit 106 is capable in identifying the respective I/O signal module unit 105 based on unique information contained in the identifier component 105z associated with the respective I/O signal module unit 105. This compartment location encoding and identification can be achieved using passive resistors. Herewith it is possible to equip the modular rack system 100 and in particular the I/O interface frame 103 as a standardized platform, as the diversification of the various modular rack system configurations (multiple combinations of various I/O signal module units 105) can now be identified by the configuration control module unit 106.

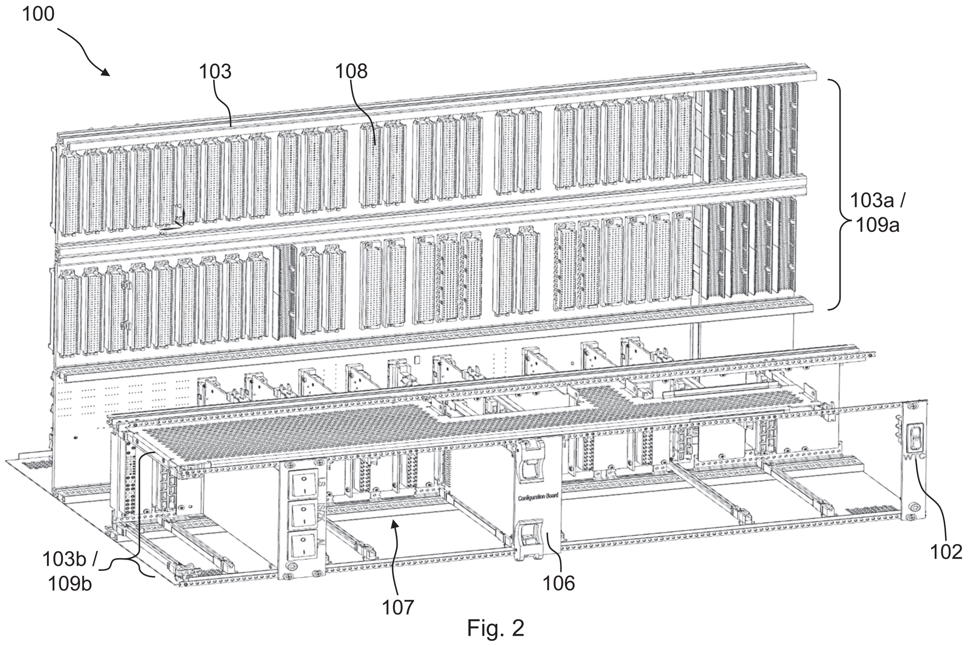

In the Figures 2 and 3, reference numeral 107 denotes a DC/DC power convertor. Preferably, one or more of such DC/DC power convertors are provided for generating DC/DC power, wherein the configuration control module unit 106 configures or sets up the one or more DC/DC power convertors 107 based on the specific unit configuration formed by the various I/O signal module units 105 as identified by the configuration control module unit 106. Herewith a further simplified modular rack configuration is achieved. Only one main power input supply 102 is needed in the rack architecture, with any complex and expensive AC/DC power convertor being replaced by one AC/DC convertor, identified with reference numeral 111. The one AC/DC convertor 111 provides DC input power for various compact, cost-effective DC/DC power convertors 107. The DC/DC power convertors 107 provide DC output power to the various I/O signal module units 105 based on the specific rack configuration as identified by the configuration control module unit 106.

Similarly as described above with respect to the identification of the respective I/O signal module units 105 using the identifier component 105z in an example, the various DC/DC power convertors 107 can be properly identified by the configuration control module unit 106, e.g. by means of passive identifiers. The identification by means of the passive identifiers allows the configuration control module unit 106 to configure or to set up the voltage and/or output current limits of the particular DC/DC power convertor in accordance with the specific rack configuration as identified and the intended semiconductor manufacturing process.

As shown in Figures 2 and 3, the I/O interface frame 103 can be defined by various interface frame sections, e.g. a first interface frame section 103a and a second interface frame section 103b. Each interface frame section 103a-103b is formed of a particular group of compartments 109a-109b destined for a group of I/O signal module units 105 in the first interface frame 103a and with the configuration control module 106 and the one or more DC/DC power convertors 107 destined to be accommodated in the second interface frame section 103b.

The use of one main power supply 102, and various DC/DC power convertors 107 ensures operator safety, prevents the occurrence of arcing, and minimizes the risk for electric shocks. The all-DC voltage level on which the modular rack system 100 according to the disclosure is operated allows the complete modular rack system architecture to be manufacture at a lower cost.

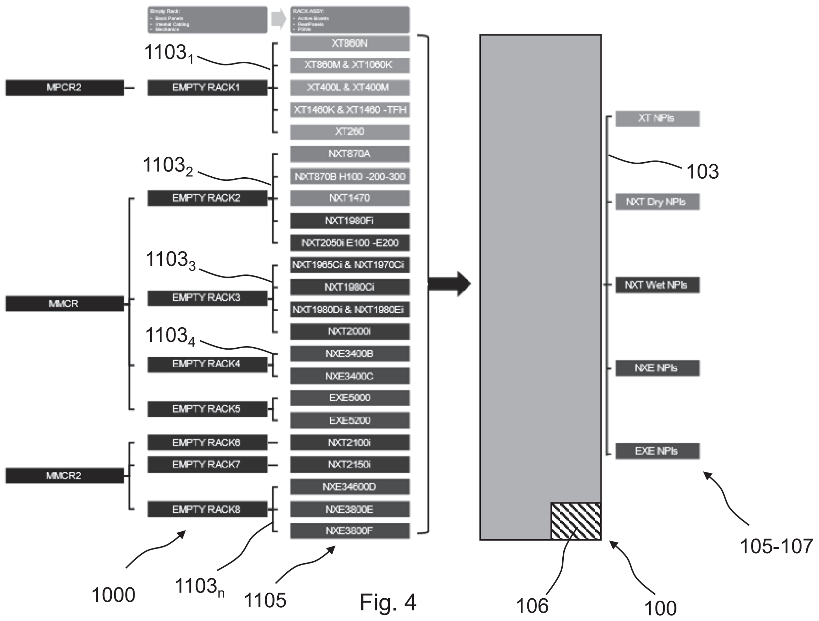

Figure 4 depicts a schematic overview of a modular rack system according to the prior art, denoted with reference numeral 1000. In the prior art setting, the rack system 1000 a large number of different I/O signal module units 1105, all having a different functionality and particularly designed for specific signal types and control functions in support of the intended semiconductor manufacturing process. Due to the diversity of functional requirements of these I/O signal module units 1105 a large number of different I/O interface frames are required in order to intended rack configurations. In Figure 4, the large number of different I/O interface frames in the prior art rack system are schematically denoted with reference numerals 11031-11032-11033-11034-...-1103n. Figure 4 also depicts in a schematic manner and for comparison purposes, the modular rack system 100 according to the disclosure, implementing one I/O interface frame 103, the configuration control module unit 106 and the various modular I/O signal module units 105 and modular DC/DC power convertors 107.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to cost constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A, B, and C.

Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

While certain embodiments have been described, these embodiments have been presented by way of example only, and are not intended to limit the scope of the present disclosures. Indeed, the novel methods, apparatuses and systems described herein can be embodied in a variety of other forms; furthermore, various omissions, substitutions and changes in the form of the methods, apparatuses and systems described herein can be made without departing from the spirit of the present disclosures. The accompanying claims and their equivalents are intended to cover such forms or modifications as would fall within the scope and spirit of the present disclosures.

## Claims

1. A modular rack system suitable for distributing electrical input/output (I/O) signals, which modular rack system comprises:
a housing;
a main power input;
a I/O interface frame mounted in the housing, the I/O interface frame structured for at least receiving a plurality of removable I/O signal module units in a specific unit configuration thereof and for distributing electrical input/output (I/O) signals to and from the removable I/O signal module units,
a configuration control module unit for uniquely identifying the removable I/O signal module units received in the specific unit configuration on the I/O interface frame and for distributing the electrical input/output (I/O) signals to the I/O interface frame based on the specific unit configuration thus identified.

2. The modular rack system suitable for distributing electrical input/output (I/O) signals according to claim 1, wherein each of the plurality of removable I/O signal module units comprises an identifier component and wherein the configuration control module unit is structured to uniquely identify a removable I/O signal module unit based on the identifier component.

3. The modular rack system suitable for distributing electrical input/output (I/O) signals according to claim 1 or 2, further comprising an AC/DC power convertor and one or more DC/DC power convertors and wherein the configuration control module unit is structured to set up the one or more DC/DC power convertors based on the specific unit configuration thus identified.

4. The modular rack system suitable for distributing electrical input/output (I/O) signals according to claim 3, wherein the configuration control module unit is structured to identify the one or more DC/DC power convertors within the specific unit configuration using passive identifier components and to set up the voltage and/or output current limit of the respective DC/DC power convertor based on the identification.

5. The modular rack system suitable for distributing electrical input/output (I/O) signals according to any one or more of the preceding claims, wherein the I/O interface frame comprises, for each defined compartment, a standardized I/O signal connector bus/type structured to mechanically and electrically interface with a corresponding standardized I/O signal connector bus/type of one of the plurality of removable I/O signal module units.

6. The modular rack system suitable for distributing electrical input/output (I/O) signals according to any one or more of the preceding claims, wherein the configuration control module unit is a removable configuration control module unit.

7. The modular rack system suitable for distributing electrical input/output (I/O) signals according to any one or more of the preceding claims, wherein the I/O interface frame is formed of a first interface frame section defining a first group of compartments structured for receiving the plurality of removable I/O signal module units and a second interface frame section defining a second group of compartments structured for receiving the configuration control module and the one or more DC/DC power convertors.

8. The modular rack system suitable for distributing electrical input/output (I/O) signals according to any one or more of the preceding claims, wherein the configuration control module unit comprises one or more power switch elements to turn on/off one or more of the I/O signal module units, one or more of the DC/DC power convertors or one or more groups of compartments.
